# EUROPÄISCHE PATENTSCHRIFT

(11) **EP 2 422 450 B1**
(45) Veröffentlichungstag und Bekanntmachung des Hinweises auf die Patenterteilung: **26.09.2018**
(21) Anmeldenummer: 10713965.1
(22) Anmeldetag: 16.04.2010
(51) Int. Cl.: H03K 17/96, H01H 19/02, H03K 17/975, H01H 3/02

(54) **PROGRAMMWÄHLER FÜR EIN HAUSGERÄT, INSBESONDERE FÜR EINE WASCHMASCHINE**
PROGRAM SELECTOR FOR A HOUSEHOLD APPLIANCE IN PARTICULAR FOR A WASHING MACHINE
SELECTEUR DE PROGRAMME POUR UN APPAREIL ÉLECTROMÉNAGER EN PARTICULIER UNE MACHINE À LAVER

(30) Priorität: 24.04.2009 DE 102009002625
(43) Veröffentlichungstag der Anmeldung: 29.02.2012
(73) Patentinhaber: BSH Hausgeräte GmbH, 81739 München (DE)
(72) Erfinder: PIEHLER, Thorsten, 93049 Regensburg (DE); PIERMEIER, Simon, 94379 Sankt Englmar (DE); REDELSTAB, Markus, 93059 Regensburg (DE); SCHIEDER, Josef, 93055 Regensburg (DE)
(86) Internationale Anmeldenummer: PCT/EP2010/055007
(87) Internationale Veröffentlichungsnummer: WO 2010/121950

(56) Entgegenhaltungen:
- DE-A1- 10 313 401
- DE-A1-102006 026 187
- DE-A1-102007 017 205
- DE-A1-102008 035 894
- DE-U1-202005 019 978
- US-A1- 2009 009 491

## Beschreibung

Die Erfindung betrifft eine Bedieneinrichtung zur Auswahl einer Funktion aus einer Mehrzahl von Funktionen eines Hausgerätes, wie beispielsweise einer Waschmaschine oder eines Waschtrockners. Die Erfindung bezieht sich des Weiteren auf ein Hausgerät mit einer derartigen Bedieneinrichtung.

Programmdrehwähler zur Auswahl von Funktionen einer Waschmaschine sind bereits aus dem Stand der Technik in vielfältiger Ausgestaltung bekannt. Die Druckschrift EP 1 527 519 B1 beschreibt einen Drehwähler aus dem Hause der Anmelderin, welche als Bedieneinrichtung zur Ein- und Ausschaltung und automatischen Steuerung einer Vielzahl unterschiedlicher Programmabläufe von elektrisch betriebenen Geräten, wie Waschmaschinen, Wäschetrocknern oder dergleichen, bereitgestellt ist. Der bekannte Drehwähler umfasst ein Bedienelement, das an einer Blende drehbar gelagert ist. Dabei ist das Bedienelement über eine mechanische Welle mit einem Drehfeldsensor verbunden.

Ein ähnlicher Drehwähler zur Auswahl von Funktionen eines Hausgerätes ist aus der Druckschrift DE 102 34 925 A1 bekannt.

Aus dem Stand der Technik sind des Weiteren kapazitive Berührungs- und Annäherungssensoren bekannt, die immer häufiger bei Hausgeräten zur Auswahl von Funktionen eingesetzt werden. Ein solcher kapazitiver Berührungs- und Annäherungssensor ist beispielsweise aus der Druckschrift DE 10 2005 041 113 A1 bekannt. Der bekannte Sensor weist eine Sensorelektrode auf, die als Teil eines Kondensators mit veränderlicher Kapazität bereitgestellt ist. Die Sensorelektrode ist dabei mit einer Auswerteschaltung verbunden. Wird ein Finger einer Bedienperson, der ein vom Potential der Sensorelektrode verschiedenes Potential, insbesondere Erdpotential, führt, an die Sensorelektrode angenähert, so wird dadurch eine Kapazitätsänderung eines die Sensorelektrode und den Finger aufweisenden Kondensators hervorgerufen. Diese Kapazitätsänderung wird dann durch die Auswerteschaltung erkannt.

Ein entsprechender Berührungs- und Annäherungssensor ist aus der Druckschrift US 2006/0145539 A1 bekannt. Bei diesem Sensor ist eine Sensorelektrode bereitgestellt, welche mit einer Auswerteschaltung elektrisch leitfähig gekoppelt ist. Am Ausgang dieser Auswerteschaltung ist ein Auswertesignal erzeugbar, dessen Frequenz in Abhängigkeit von der Kapazität eines die Sensorelektrode aufweisenden Kondensators veränderbar ist. Anhand der Frequenz kann somit festgestellt werden, ob sich ein Finger einer Bedienperson an die Sensorelektrode annähert. Es kann somit die Betätigung eines Bedienknopfes oder dergleichen auf kapazitivem Wege erkannt werden.

Ein kapazitiver Annäherungs- und Berührungssensor ist außerdem aus dem Dokument DE 102 50 395 A1 bekannt.

Zum einen ist an den bekannten Programmdrehwählern als nachteilig der Umstand anzusehen, dass sie mechanisch aufwendig ausgebildet sind. Ein herkömmlicher Programmdrehwähler bedarf nämlich einer mechanischen Verbindung zwischen einem an einer Bedienblende drehbar angeordneten Bedienelement und einer Auswerteschaltung, die hinter der Blende, also im Inneren des Hausgerätes, angeordnet ist. Um eine solche mechanische Verbindung zu gewährleisten, muss in der Bedienblende eine Durchgangsöffnung bereitgestellt werden, so dass Wasser und Schmutz in das Hausgeräteinnere eindringen können. Solche mechanischen Programmdrehwähler sind außerdem aufgrund der mechanischen Verbindung verschleißbehaftet.

Zum anderen sind die bekannten kapazitiven Bewegungs- und Annäherungssensoren zwar kostengünstiger und weniger verschleißbehaftet als die mechanischen Drehwähler, mit den bisher bekannten kapazitiven Sensoren kann jedoch die durch einen herkömmlichen Drehwähler etablierte Bedienphilosophie bzw. das Bedienkonzept nicht aufrechterhalten werden.

Die Druckschrift DE 10 2006 054 764 A1 beschreibt eine Bedienvorrichtung für ein Elektrokochfeld. Die Bedienvorrichtung beinhaltet ein Bedienelement, welches auf einer Auflage aufgesetzt ist. Selbiges Bedienelement weist an einer Oberseite sowie an einer Unterseite jeweils eine Vielzahl von elektrisch leitfähigen kreisringsegmentartigen Metallflächen auf. Die Metallflächen sind paarweise miteinander elektrisch verbunden: Jeweils eine an der Oberseite angeordnete Metallfläche ist mit einer zugeordneten Metallfläche an der Unterseite verbunden. Auch unterhalb der Auflage befindet sich eine Vielzahl von elektrischen Elektroden, die mit einer Schaltungsanordnung gekoppelt sind. Das Auflegen eines Fingers auf eine der Metallflächen an der Oberseite wird direkt an eine entsprechende Metallfläche an der Unterseite gekoppelt und kann kapazitiv von einer Elektrode unterhalb der Auflage erfasst und von der Schaltungsanordnung ausgewertet werden.
Aus der Druckschrift DE 20 2005 019 978 U1 ist eine Bedienvorrichtung für ein Elektrogerät bekannt. Eine Bedieneinheit ist an einer Bedienblende bzw. Auflagefläche des Elektrogeräts drehbeweglich oder schiebebeweglich gelagert. Die Bedieneinheit beinhaltet einen Dreh- oder Schieberegler, auf welchem ein weiteres Schaltmittel angeordnet ist. Ein Steuergerät ist unterhalb der Auflagefläche angeordnet.
Die Druckschrift WO 2005/019766 A2 beschreibt eine Bedieneinrichtung für elektrische Geräte. Die Bedieneinrichtung umfasst einen resistiven Streifen, in welchen eine Vielzahl von elektrischen Anschlüssen integriert sind. Die elektrischen Anschlüsse sind mit einer elektronischen Schaltungsanordnung gekoppelt. Die Anschlüsse sind jeweils mit einem Erfassungskanal der Schaltungsanordnung verbunden. Die Schaltungsanordnung kann die Stelle an dem resistiven Streifen erkennen, die eine Bedienperson berührt.
Aus der Druckschrift WO 2007/014780 A1 ist ein Bedienelement bekannt, welches in Kraftfahrzeugen eingesetzt werden kann.
Aus dem Dokument DE 10 2007 017 205 A1 ist eine Bedienvorrichtung für eine Bedieneinheit einer Fahrzeugkomponente bekannt, welche mit einem feststehend angeordneten Bedienelement ausgebildet ist, das eine Außenseite aufweist, an welcher das Bedienelement mit den Fingern einer Hand ergreifbar ist. Ein Sensor erfasst das Gleiten des Fingers entlang der und über die Außenseite des Bedienelements und erzeugt ein Sensorsignal, welches das Ausmaß der Fingerbewegung repräsentiert.

Ferner offenbart die US 2009/0009491 A1 eine Bedienvorrichtung nach dem Oberbegriff des Anspruchs 1 mit einem kapazitiv sensitiven Bedienknopf.

Es ist Aufgabe der Erfindung eine mechanisch robuste Bedieneinrichtung zur Auswahl unterschiedlicher Programmabläufe eines Hausgerätes bereitzustellen.

Diese Aufgabe wird erfindungsgemäß durch eine Bedieneinrichtung mit den Merkmalen nach Patentanspruch 1 sowie durch ein Hausgerät, welches die Merkmale nach Patentanspruch 8 aufweist, gelöst. Vorteilhafte Ausgestaltungen der Erfindung sind in den abhängigen Ansprüchen angegeben.

Eine erfindungsgemäße Bedieneinrichtung dient zur Auswahl einer Funktion aus einer Mehrzahl von Funktionen eines Hausgerätes. Diese Bedieneinrichtung umfasst eine kapazitive Berührungs- oder Annährungssensorvorrichtung, die eine Mehrzahl von elektrisch voneinander isolierten Sensorelektroden aufweist. Die Sensorelektroden sind dabei mit einer Auswerteschaltung elektrisch gekoppelt. Die Sensorelektroden sind an einem von einer Bedienblende abstehenden Basiskörper eines Bedienelements angebracht und gehören somit selbst zum Bedienelement. Die Sensorelektroden sind aus elektrisch leitfähigem Material, wie beispielsweise Kupfer, ausgebildet. Der Basiskörper kann insbesondere aus elektrisch isolierendem Material ausgebildet sein. Der Basiskörper ist mit der Bedienblende bewegungsfest verbunden.

Es wird somit eine Bedieneinrichtung geschaffen, bei welcher einerseits das Bedienkonzept bzw. die Bedienphilosophie eines herkömmlichen Bedienelements bzw. Programmwählers, wie z.B. eines Programmdrehwählers, und andererseits eine verschleißfreie Bedienung gewährleistet werden. Insbesondere dann, wenn der Basiskörper des Bedienelements mit der Bedienblende bewegungsfest verbunden ist, kann eine Funktion bzw. ein Programm des Hausgerätes durch eine Gleitbewegung eines oder mehrerer Finger an dem Bedienelement oder durch ein einfaches Berühren des Bedienelements an einer Stelle ausgewählt werden.

Bei der Bedieneinrichtung wird eine z.B. durch eine Relativbewegung der Hand oder eines Fingers einer Bedienperson bezüglich des Bedienelements verursachte Beeinflussung des kapazitiven Nahfeldes über den an dem Basiskörper angebrachten Sensorelektroden gemessen. Aufgrund dieser Beeinflussung wird dann insbesondere ein bei der Relativbewegung zurückgelegter Weg durch die Auswerteschaltung ermittelt, so dass auf eine ausgewählte Funktion des Hausgerätes geschlossen werden kann. Es kann auch eine durch eine Annäherung eines Fingers an eine bestimmte Stelle des Bedienelements oder durch eine Berührung dieser Stelle verursachte Beeinflussung des kapazitiven Nahfeldes über den Sensorelektroden gemessen werden. Bei diesem Bedienkonzept wird durch die Auswerteschaltung erkannt, welche Sensorelektrode berührt oder beeinflusst wurde, und die Auswerteschaltung kann daraus auf die ausgewählte Funktion zurück schließen.

Die Auswertung der jeweiligen kapazitiven Eigenschaften der Sensorelektroden kann beispielsweise, wie im Gegenstand gemäß Druckschrift DE 10 2005 041 113 A1 erfolgen. Danach kann die Auswerteschaltung für jede Sensorelektrode einen Transistor, wie z.B. einen PNP-Bipolartransistor, aufweisen, dessen Basis über einen Ohmschen Widerstand mit der Sensorelektrode verbunden ist. Mit dem Emitter des Transistors kann ein Ausgang eines Mikrokontrollers gekoppelt sein, an welchem ein Taktsignal vom Mikrokontroller abgegeben wird. Der Kollektor des Transistors kann mit einem Abtast-Halter-Glied (Sample and Hold) verbunden sein, durch welches ein Gleichspannungssignal an einen Eingang des Mikrokontrollers erzeugbar ist. Anhand des Gleichspannungssignals kann die Kapazitätsänderung des die Sensorelektrode umfassenden Kondensators erfasst und die Betätigung der Bedieneinrichtung erkannt werden. Die Änderung der jeweiligen Kapazitätseigenschaften kann somit anhand der Amplitude eines Gleichspannungssignals erkannt werden.

Alternativ kann die Auswerteschaltung derart ausgebildet sein, dass die Änderung der jeweiligen Kapazitätseigenschaften in Abhängigkeit von der Frequenz eines Wechselspannungssignals erkennbar ist.

Die Bedieneinrichtung wird als Annäherungs-Sensor verwendet. Die ist Auswerteschaltung dazu ausgebildet, eine Annäherung einer Bedienperson an das Bedienelement zu erkennen. Es kann zum Beispiel so aussehen, dass die Auswerteschaltung nach Erkennen einer Bedienperson das Hausgerät von einem Standby-Zustand in einen Aktivzustand überführt.

Der Basiskörper des Bedienelements ist zylinderförmig ausgebildet. Dann ist das gesamte Bedienelement einschließlich des Basiskörpers und der daran angeordneten Sensorelektroden insbesondere im Wesentlichen zylinderförmig ausgebildet. Bei dieser Ausführungsform wird ein Bedienelement geschaffen, welches die Form entsprechend einem herkömmlichen Programmdrehwähler aufweist, welches jedoch mit der Mehrzahl von Sensorelektroden versehen ist und mit der Bedienblende bevorzugt fest verbunden ist. Hierbei sind zwei Bedienkonzepte vorgesehen. Gemäß dem ersten Bedienkonzept kann die Bedienperson das zylinderförmig ausgebildete Bedienelement mit mehreren Fingern berühren und mit den Fingern eine Gleitbewegung an dem Bedienelement ausführen. Die Auswerteschaltung kann dann den durch die Finger an dem Bedienelement zurückgelegten Weg erfassen, indem sie die Änderung der Kapazitäten der die Sensorelektroden umfassenden Kondensatoren auswertet. Aufgrund des durch die Gleitbewegung zurückgelegten Weges kann die Auswerteschaltung die durch die Bedienperson ausgewählte Funktion erkennen. Gemäß einem zweiten Bedienkonzept kann die Bedienperson mit nur einem Finger das Bedienelement an einer Stelle berühren oder den Finger an eine Position des Bedienelements annähern, um eine Funktion des Hausgerätes anzuwählen.

Um die Möglichkeit bereitzustellen, eine Funktion des Hausgerätes mit einer gleichen Bewegung wie bei einem herkömmlichen Programmdrehwähler auszuwählen, sind die Sensorelektroden bevorzugt an einem Außenumfang des zylinderförmigen Basiskörpers, insbesondere äquidistant, angeordnet. Die Bedienperson kann somit das Bedienelement am Außenumfang - wie bei einem herkömmlichen Programmdrehwähler - berühren und eine gleitende Drehbewegung am Bedienelement ausführen, um die Funktion auszuwählen. Dies erhöht die Bedienfreundlichkeit der Bedieneinrichtung im Vergleich zu herkömmlichen kapazitiven Berührungssensoren.

Die Sensorelektroden sind zumindest an einer von der Bedienblende abgewandten Stirnseite des Basiskörpers des Bedienelements angeordnet. Eine Bedienperson kann dann die Stirnseite des Bedienelements berühren, um eine Funktion des Hausgerätes auszuwählen. Bei dieser Ausführungsform erstrecken sich die Sensorelektroden insbesondere hin zu einem Zentrum der Stirnwand des Basiskörpers, so dass die Sensorelektroden an der Stirnseite gleichmäßig verteilt in Form eines Sterns angeordnet sind.

Die Sensorelektroden können an einer Folie - z.B. Kunststofffolie - angebracht sein, die an dem Basiskörper angeordnet ist. Bei dieser Ausführungsform können die Sensorelektroden durch eine leitfähige Beschichtung der Folie gebildet sein. Dies hat den Vorteil, dass die Sensorelektroden auch an einer gewölbten Oberfläche des Basiskörpers, wie insbesondere an einem zylinderförmigen Basiskörper, angebracht - z.B. aufgeklebt - werden können.

Es hat sich als besonders vorteilhaft herausgestellt, wenn der Basiskörper mit einer elektrisch isolierenden Bedienkappe ummantelt ist. Dann sind die Sensorelektroden, die am Basiskörper angebracht sind, mittels der Bedienkappe abgedeckt. Auf diesem Wege wird erreicht, dass die Bedienperson das Bedienelement nicht direkt an den Sensorelektroden, sondern über die Bedienkappe berühren kann. Die Bedienperson berührt somit nur die Bedienkappe und ändert die Kapazität zwischen den jeweiligen Sensorelektroden und dem elektrischen Erdpotential. Der Bedienperson wird dabei der Eindruck vermittelt, dass sie einen herkömmlichen Programmdrehwähler betätigt.

Nun sind zwei Alternativen vorgesehen. Die Bedienkappe kann am Basiskörper bewegbar, insbesondere drehbar, angeordnet sein oder sie kann mit dem Basiskörper über die Sensorelektroden bewegungsfest verbunden sein.

Zur Erfindung gehört auch ein Hausgerät, welches eine erfindungsgemäße Bedieneinrichtung umfasst. Unter einem Hausgerät wird hier allgemein ein Gerät verstanden, das zur Haushaltsführung eingesetzt wird. Das kann ein Haushaltsgroßgerät sein, wie beispielsweise eine Waschmaschine, ein Wäschetrockner, ein Waschtrockner, eine Geschirrspülmaschine, ein Gargerät, eine Dunstabzugshaube, ein Kältegerät oder ein Klimagerät. Das kann aber auch ein Haushaltskleingerät sein, wie beispielsweise ein Kaffeevollautomat, eine Küchenmaschine oder ein Staubsauger.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Erfindung wird nun anhand eines bevorzugten Ausführungsbeispiels sowie anhand der beigefügten Zeichnungen näher erläutert. Dabei zeigen:
- Fig. 1: in schematischer und perspektivischer Darstellung eine Frontseite einer Bedienblende mit einem davon abstehenden Basiskörper eines Bedienelements, wobei am Basiskörper eine Mehrzahl von Sensorelektroden des Bedienelements angebracht sind; und
- Fig. 2: in schematischer und perspektivischer Darstellung die Frontseite der Bedienblende gemäß Fig. 1, wobei an den Basiskörper eine Bedienkappe bzw. eine Bedienhülse aufgeschoben ist.

In den Figuren werden gleiche und funktionsgleiche Elemente mit den gleichen Bezugszeichen versehen.

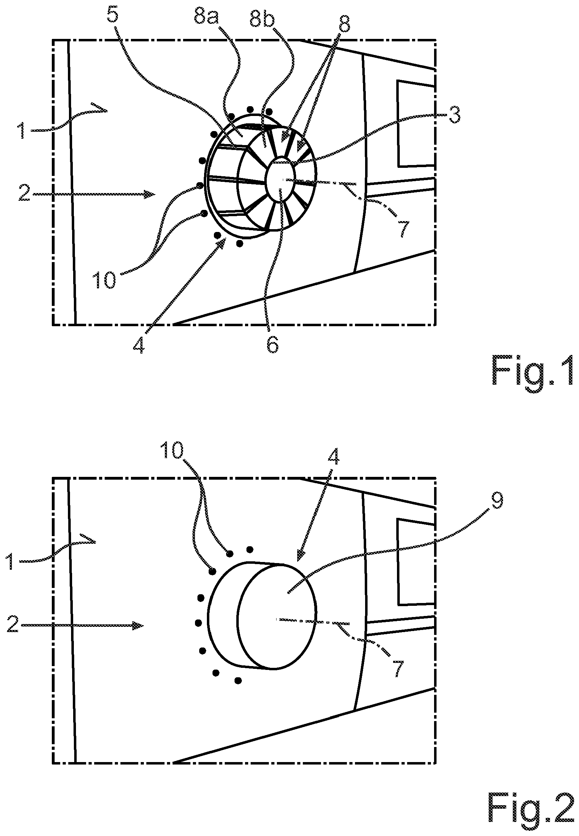

Fig. 1 zeigt eine Frontseite 1 einer Bedienblende 2 eines Hausgeräts zur Pflege von Wäschestücken, insbesondere einer Waschmaschine. An der Frontseite 1 der Bedienblende 2 ist ein Basiskörper 3 eines Bedienelements 4 angeordnet, welcher mit der Blende 2 fest verbunden ist. Der Basiskörper 3 ist hier aus einem elektrisch isolierenden Material bereitgestellt und in Form eines Zylinders mit einem Außenumfang 5 und einer von der Frontseite 1 der Bedienblende 2 abgewandeten Stirnwand 6 ausgebildet. Dabei steht der Basiskörper 3 von der Bedienblende 2 ab, wobei eine Mittelachse 7 des Basiskörpers 3 wenigstens etwa quer zur Frontseite 1 der Bedienblende 2 verläuft.

An dem Basiskörper 3 sind eine Mehrzahl von Sensorelektroden 8 angebracht, die beispielsweise über jeweils eine elektrische Leitung sowie über eine gemeinsame Steckleiste (in den Figuren nicht dargestellt) mit einer gemeinsamen Auswerteschaltung elektrisch gekoppelt sind. Die Sensorelektroden 8 sind durch ein elektrisch leitfähiges Material, wie beispielsweise Kupfer, bereitgestellt. Die Sensorelektroden 8 sind dabei galvanisch voneinander getrennt bzw. voneinander elektrisch entkoppelt angeordnet. Sie können auch an einer Folie angebracht und durch eine leitfähige Beschichtung derselben gebildet sein.

Die Sensorelektroden 8 sind jeweils abschnittsweise sowohl am Außenumfang 5 als auch an der Stirnseite 6 des Basiskörpers 3 angebracht. Dabei erstrecken sich die Sensorelektroden 8 jeweils von der Frontseite 1 der Bedienblende 2 über den Außenumfang 5 parallel zueinander sowie parallel zur Mittelachse 7, um sich dann an der Stirnwand 6 des Basiskörpers 3 im Bereich der Mittelachse 7 sternförmig zu treffen. Somit sind die Sensorelektroden 8 jeweils aus zwei Abschnitten 8a, 8b gebildet, einem ersten Abschnitt 8a, der in Form eines Streifens am Außenumfang 5 angeordnet ist, und einem zweiten Abschnitt 8b, der im Wesentlich kreissegmentförmig ausgebildet und an der Stirnwand 6 des Basiskörpers 3 angebracht ist.

Die Auswerteschaltung ist dabei dazu ausgebildet, die Kapazität zwischen jeweils einer Sensorelektrode 8 und dem elektrischen Erdpotential zu messen. Diese Kapazität kann beispielsweise durch die Annäherung eines metallischen oder nichtmetallischen Stoffes an eine aktive Zone der Sensorelektroden 8 beeinflusst werden. Dieses Phänomen wird hier zur Auswahl einer Funktion aus einer Mehrzahl von Funktionen bzw. Programmabläufen des Hausgerätes ausgenutzt. Dabei kann die Auswerteschaltung die ausgewählte Funktion anhand der Änderung der einzelnen Kapazitäten der Sensorelektroden 8 bezüglich des elektrischen Erdpotentials erkennen. Dies kann beispielsweise, wie im Gegenstand gemäß Druckschrift DE 10 2005 041 113 A1 und wie dazu in der Beschreibungseinleitung dargelegt, erfolgen.

Wie in Fig. 2 dargestellt ist, weist das Bedienelement 4 eine Bedienkappe 9 auf, mittels welcher der Basiskörper 3 und die Sensorelektroden 8 abgedeckt sind. Dabei ist die Bedienkappe 9 in Form einer Hülse ausgebildet und deckt sowohl den Außenumfang 5 als auch die Stirnseite 6 des Basiskörpers 3 ab. Außerdem ist die Bedienkappe 9 aus einem elektrisch isolierenden Material bereitgestellt.

Es sind zwei Möglichkeiten hinsichtlich der Anordnung der Bedienkappe 9 am Basiskörper 3 vorgesehen. Die Bedienkappe 9 kann am Basiskörper 3 drehbar angeordnet sein oder mit dem Basiskörper 3 und/oder mit der Bedienblende 2 drehfest verbunden sein. Ist die Bedienkappe 9 am Basiskörper 3 drehbar angeordnet, so wird das Bedienelement 4 durch Drehen der Bedienkappe 9 bezüglich des Basiskörpers 3 und der Sensorelektroden 8 bedient. Ist die Bedienkappe 9 fest mit den Elektroden 8 und dem Basiskörper 3 verbunden, so wird das Bedienelement 4 durch eine Relativbewegung wenigstens eines Fingers bezüglich der Bedienkappe 9, insbesondere durch eine Gleitbewegung wenigstens eines Fingers an der Bedienkappe 9, bedient.

Gemäß dem Beispiel wird somit ein Bedienelement 4 geschaffen, welches die Form eines herkömmlichen Programmdrehwählers ausweist, das jedoch eine Berührungs- oder Annäherungssensorvorrichtung einschließlich der Mehrzahl von Sensorelektroden 8 umfasst. Beim Betätigen des Bedienelements 4 bzw. beim Auswählen einer Funktion des Hausgerätes sind zwei unterschiedliche, jedoch gleichzeitig verfügbare, Bedienkonzepte vorgesehen:
Gemäß einem ersten Bedienkonzept kann eine Funktion des Hausgerätes bzw. ein Programmablauf durch ein einfaches Berühren der Bedienkappe 9 an einer Stelle mit lediglich einem Finger oder durch das Annähern lediglich eines Fingers an eine Stelle der Bedienkappe 9 ausgewählt werden. Die ausgewählte Funktion wird dann anhand der Änderung von Kapazitäten zwischen jeweils einer Sensorelektrode 8 und dem elektrischen Erdpotential erkannt.

Gemäß einem zweiten Bedienkonzept kann die Bedienkappe 9 mit mehreren Fingern am Außenumfang ergriffen werden (Multitouch-Bedienung). Dann kann die Bedienkappe 9 bezüglich der Sensorelektroden 8 gedreht werden oder die Bedienperson kann eine Gleit-Drehbewegung am Außenumfang der Bedienkappe 9 ausführen. Jeweils wird ein zurückgelegter Winkelweg durch die Auswertung der einzelnen Kapazitäten erfasst, und in Abhängigkeit von dem erfassten zurückgelegten Weg wird die durch die Bedienperson ausgewählte Funktion erkannt. Sowohl beim Gleiten am Außenumfang der Bedienkappe 9 als auch beim Drehen derselben wird der Bedienperson der Eindruck vermittelt, dass sie einen herkömmlichen Programmdrehwähler betätigt.

Wie in den Figuren 1 und 2 dargestellt, ist an der Frontseite 1 der Bedienblende 2 außerdem eine optische Anzeigeeinrichtung angeordnet, mittels welcher der Bedienperson die jeweils gegenwärtig angewählte Funktion angezeigt wird. Diese Anzeigeeinrichtung kann Leuchtdioden 10 umfassen, die an der Frontseite 1 der Bedienblende 2 um das Bedienelement 4 herum angeordnet sind. Die Leuchtdioden 10, die beispielsweise organische Leuchtdioden (OLED) oder herkömmliche LEDs sein können, sind dann in einem gleichen Abstand zur Mittelachse 7 des Bedienelements 4 an der Bedienblende 2 angeordnet. Die Anordnung der Leuchtdioden 10 sowie deren relative Positionierung zueinander können jedoch beliebig sein. Zum Beispiel können die Leuchtdioden 10 insgesamt in der Form eines Balkens an der Bedienblende 2 angeordnet sein. Dabei sind eine horizontale, eine vertikale, wie auch eine schräge Anordnung möglich. Die Leuchtdioden 10 können aber auch einzeln an der Bedienblende 2 verteilt angeordnet sein. Wird durch die Bedienperson eine Funktion des Hausgerätes angewählt, so beginnt eine dieser Funktion zugeordnete und diese Funktion signalisierende Leuchtdiode 10 zu leuchten. Diese Leuchtdiode 10 wird ausgeschaltet, sobald eine andere Funktion des Hausgerätes angewählt und eine benachbarte Leuchtdiode 10 eingeschaltet wird, indem z.B. eine Gleitbewegung am Bedienelement 4 ausgeführt wird. Ergänzend oder alternativ kann die gewählte Funktion auch an einem Display angezeigt werden.

Insgesamt wird gemäß dem Beispiel ein Bedienelement 4 geschaffen, welches die Form eines herkömmlichen Programmdrehwählers aufweist, das jedoch keine mechanische Verbindung - z.B. in Form einer Welle - zum Hausgeräteinneren aufweist und somit besonders verschleißarm ausgeführt ist. Beim Aufrechterhalten des Bedienkonzeptes eines herkömmlichen Programmdrehwählers werden somit die Robustheit und die elektrische Betriebssicherheit der Bedieneinrichtung erhöht.

### Bezugszeichenliste

- 1: Frontseite
- 2: Bedienblende
- 3: Basiskörper
- 4: Bedienelement
- 5: Außenumfang
- 6: Stirnwand
- 7: Mittelachse
- 8: Sensorelektroden
- 9: Bedienkappe
- 10: Leuchtdioden

## Patentansprüche

1. Bedieneinrichtung zur Auswahl einer Funktion aus einer Mehrzahl von Funktionen eines Hausgerätes, mit einer kapazitiven Berührungs- oder Annäherungssensorvorrichtung, die eine Mehrzahl von elektrisch voneinander isolierten Sensorelektroden (8) aufweist, die mit einer Auswerteschaltung elektrisch gekoppelt sind, wobei die Sensorelektroden (8) an einem von einer Bedienblende (2) abstehenden Basiskörper (3) eines Bedienelements (4) angebracht sind und der Basiskörper (3) mit der Bedienblende (2) bewegungsfest verbunden ist, wobei die Auswerteschaltung dazu ausgebildet ist, eine Annäherung einer Bedienperson an das Bedienelement zu erkennen, wobei der Basiskörper (3) des Bedienelements (4) zylinderförmig ausgebildet ist und die Sensorelektroden (8) jeweils abschnittsweise an einem Außenumfang (5) des zylinderförmigen Basiskörpers (3) angeordnet sind, **dadurch gekennzeichnet, dass** die Sensorelektroden auch an einer von der Bedienblende (2) abgewandten Stirnwand (6) abschnittweise sternförmig angeordnet sind und sich zu einem Zentrum (7) der von der Bedienblende (2) abgewandten Stirnwand (6) des Basiskörpers (3) hin erstrecken.

2. Bedieneinrichtung nach Anspruch 1, **dadurch gekennzeichnet, dass** die Sensorelektroden (8) äquidistant in Umfangsrichtung, angeordnet sind.

3. Bedieneinrichtung nach einem der vorhergehenden Ansprüche, **dadurch gekennzeichnet, dass** die Sensorelektroden (8) an einer Folie angeordnet sind, welche an dem Basiskörper (3) angebracht ist, wobei bevorzugt die Sensorelektroden (8) durch eine leitfähige Beschichtung der Folie gebildet sind.

4. Bedieneinrichtung nach einem der vorhergehenden Ansprüche, **dadurch gekennzeichnet, dass** der Basiskörper (3) mit einer elektrisch isolierenden Bedienkappe (9) ummantelt ist, mit welcher die Sensorelektroden (8) abgedeckt sind.

5. Bedieneinrichtung nach Anspruch 4, **dadurch gekennzeichnet, dass** die Bedienkappe (9) am Basiskörper (3) bewegbar, insbesondere drehbar, angeordnet ist.

6. Bedieneinrichtung nach Anspruch 4, **dadurch gekennzeichnet, dass** die Bedienkappe (9) mit dem Basiskörper (3) über die Sensorelektroden (8) bewegungsfest verbunden ist.

7. Bedieneinrichtung nach einem der vorhergehenden Ansprüche, **dadurch gekennzeichnet, dass** die Auswerteschaltung dazu ausgebildet ist, einen bei einer Bewegung von wenigstens zwei Fingern einer Bedienperson relativ zu den Sensorelektroden, insbesondere bei einer Gleitbewegung der Finger an dem Bedienelement, zurückgelegten Weg zu erfassen und die durch die Bedienperson ausgewählte Funktion abhängig von diesem Weg zu erkennen.

8. Hausgerät mit einer Bedieneinrichtung nach einem der vorhergehenden Ansprüche.

## Claims

1. Operator control for selecting a function from a plurality of functions of a domestic appliance, having a capacitive touch or proximity sensor apparatus which has a plurality of sensor electrodes (8) which are electrically insulated from one another and which are electrically coupled to an evaluation circuit, wherein the sensor electrodes (8) are attached to a base element (3) of a control element (4) which projects from a control panel (2) and the base element (3) is immovably connected to the control panel (2), wherein the evaluation circuit is embodied to identify an operator approaching the control element, wherein the base element (3) of the control element (4) is embodied to be cylindrical and the sensor electrodes (8) are each arranged in sections on an outer periphery (5) of the cylindrical base element (3), **characterised in that** the sensor electrodes are also arranged in a star shape on sections of a front wall (6) facing away from the control panel (2) and extend toward a centre (7) of the front wall (6) of the base element (3) facing away from the control panel (2).

2. Operator control according to claim 1, **characterised in that** the sensor electrodes (8) are arranged equidistantly in the peripheral direction.

3. Operator control according to one of the preceding claims, **characterised in that** the sensor electrodes (8) are arranged on a film, which is attached to the base element (3), wherein the sensor electrodes (8) are preferably formed by a conductive coating of the film.

4. Operator control according to one of the preceding claims, **characterised in that** the base element (3) is encased with an electrically insulating control cap (9), with which the sensor electrodes (8) are covered.

5. Operator control according to claim 4, **characterised in that** the control cap (9) is arranged movably, in particular rotatably, on the base element (3).

6. Operator control according to claim 4, **characterised in that** the control cap (9) is immovably connected to the base element (3) by way of the sensor electrodes (8).

7. Operator control according to one of the preceding claims, **characterised in that** the evaluation circuit is embodied to detect a distance covered with a movement of at least two fingers of an operator relative to the sensor electrodes, in particular with a sliding movement of the fingers on the control element, and to identify the function selected by the operator as a function of this distance.

8. Domestic appliance with an operator control according to one of the preceding claims.

## Revendications

1. Système de commande pour la sélection d'une fonction parmi une pluralité de fonctions d'un appareil électroménager, avec un dispositif de détection capacitif de contact ou de proximité qui comprend une pluralité d'électrodes de détection (8) isolées électriquement les unes des autres, lesquelles sont couplées électriquement à un circuit d'évaluation, dans lequel les électrodes de détection (8) sont montées sur un corps de base (3), faisant saillie d'un panneau de commande (2), d'un élément de commande (4) et le corps de base (3) est relié fixement au panneau de commande (2), dans lequel le circuit d'évaluation est conçu pour détecter une proximité d'un opérateur de l'élément de commande, dans lequel le corps de base (3) de l'élément de commande (4) est de forme cylindrique et les électrodes de détection (8) sont disposées respectivement par sections sur une périphérie extérieure (5) du corps de base (3) cylindrique, **caractérisé en ce que** les électrodes de détection sont disposées également par sections en forme d'étoile sur une paroi frontale (6) opposée au panneau de commande (2) et s'étendent jusqu'à un centre (7) de la paroi frontale (6), opposée au panneau de commande (2), du corps de base (3).

2. Système de commande selon la revendication 1, **caractérisé en ce que** les électrodes de détection (8) sont disposées à équidistance dans la direction périphérique.

3. Système de commande selon l'une des revendications précédentes, **caractérisé en ce que** les électrodes de détection (8) sont disposées sur un film, lequel est fixé sur le corps de base (3), dans lequel les électrodes de détection (8) sont de préférence formées par un revêtement conducteur du film.

4. Système de commande selon l'une des revendications précédentes, **caractérisé en ce que** le corps de base (3) est enveloppé d'un couvercle de commande (9) électriquement isolant avec lequel sont recouvertes les électrodes de détection (8).

5. Système de commande selon la revendication 4, **caractérisé en ce que** le couvercle de commande (9) est disposé mobile, en particulier rotatif, sur le corps de base (3).

6. Système de commande selon la revendication 4, **caractérisé en ce que** le couvercle de commande (9) est relié fixement au corps de base (3) par l'intermédiaire des électrodes de détection (8).

7. Système de commande selon l'une des revendications précédentes, **caractérisé en ce que** le circuit d'évaluation est conçu pour enregistrer un chemin parcouru lors d'un déplacement d'au moins deux doigts d'un opérateur par rapport aux électrodes de détection, en particulier lors d'un déplacement de glissement des doigts sur l'élément de commande, et pour détecter la fonction sélectionnée par l'opérateur en fonction de ce chemin.

8. Appareil électroménager avec un système de commande selon l'une des revendications précédentes.
